# EUROPÄISCHE PATENTSCHRIFT

(11) **EP 0 417 628 B1**
(45) Veröffentlichungstag und Bekanntmachung des Hinweises auf die Patenterteilung: **26.01.1994**
(21) Anmeldenummer: 90117060.5
(22) Anmeldetag: 05.09.1990
(51) Int. Cl.: C04B 35/00, C01G 3/00, H01L 39/24

(54) **Verfahren zur Herstellung eines Supraleiters durch Fällung**
Process for preparing a superconductor by precipitation
Procédé de préparation d'un supraconducteur par précipitation

(30) Priorität: 09.09.1989 DE 3930118
(43) Veröffentlichungstag der Anmeldung: 20.03.1991
(73) Patentinhaber: HOECHST AKTIENGESELLSCHAFT, 65926 Frankfurt am Main (DE)
(72) Erfinder: Becker, Winfried, Dr., D-6233 Kelkheim (Taunus) (DE)

(56) Entgegenhaltungen:
- EP-A- 0 261 590
- EP-A- 0 287 064
- WO-A-88/10235
- G. JANDER / E. BLASIUS: "Lehrbuch der analytischen und präparativen anorganischen Chemie" 1986, S. HIRZEL VERLAG, LEIBZIG, DE
- SOLID STATE COMMUNICATIONS. vol. 64, no. 6, November 1987, OXFORD GB Seiten 881 - 883; X. Z. Wang et al.: "THE OXALATE ROUTE TO SUPERCONDUCTING YBa2Cu3O7-x"
- CHEMICAL ABSTRACTS, vol. 113, no. 12, 17 September 1990 Columbus, Ohio, USA L. Lingqing et al.: "Preparation of superconductors of yttrium barium copper oxide by the oxalate method" Seite 695; linke Spalte; ref. no. 107249S

## Beschreibung

Die vorliegende Erfindung betrifft ein Verfahren zur Herstellung eines phasenreinen, Kupfer enthaltenden, oxidkeramischen Supraleiters, der neben Kupfer noch mindestens zwei Metalle ausgewählt aus der Gruppe Y, Ba, Ca, Sr, La, Tl, Pb oder der Seltenen Erden enthält, durch quantitative Copräzipitation der Metalloxalate aus entsprechend eingestellten Lösungen.

Die Herstellung von YBa₂Cu₃O₇₋ₓ-Keramiken wird erstmals in Physical Review Letters, Bd. 58 (1987), Seite 908 beschrieben. Nach diesem Verfahren werden die Ausgangsverbindungen Y₂O₃, BaCO₃ und CuO gut vermengt. Das Gemenge wird gepreßt, danach über mehrere Stunden bei 950°C gesintert und schließlich im Sauerstoffstrom langsam auf Raumtemperatur abgekühlt. In der Folge wurde gefunden, daß Sintertemperatur, Abkühlungsrate und Gasatmosphäre die physikalischen Eigenschaften des erhaltenen Körpers, insbesondere die für die Supraleitung verantwortlichen, erheblich beeinflussen.

Trotz großen experimentellen Aufwandes zur Optimierung der Darstellungsbedingungen ist die Situation hinsichtlich der Gewinnung phasenreiner Pulver oder Keramiken immer noch unbefriedigend. Als häufigste Nebenphasen wurden BaCuO₂, Y₂BaCuO₅ und CuO in YBa₂Cu₃O₇₋ₓ identifiziert. Ähnliche Probleme bestehen auch bei der Herstellung anderer Kupfer enthaltender oxidkeramischer Supraleiter.

Um örtliche Inhomogenitäten zu vermeiden, die sich möglicherweise durch Sintern der Oxide nicht genügend beseitigen lassen, hat man schon versucht, metallhaltige Ausgangsmaterialien durch Copräzipitation zu erhalten.

Aus EP 303 249 ist ein Verfahren zur Herstellung von YBa₂Cu₃Oₓ-Supraleitern bekannt, bei dem man eine wäßrige Lösung, die die Nitrtate von Y, Ba und Cu im Atomverhältnis von Y:Ba:Cu = 1:2:3 enthält, mit Oxalat ausfällt. Das Oxalat wird isoliert und zunächst bei 700°C bei einem Sauerstoffpartialdruck von 0,01 Torr und dann als Formkörper bei 850°C oder 900°C in Sauerstoff gebrannt. Dabei können bei Co-Präzipitaten, die aus wäßriger Lösung gefällt werden, wegen der in der Regel unterschiedlichen Löslichkeiten der ausgefällten Salze im Wasser Schwierigkeiten auftreten (Solid State Communications Bd. 64 (1987), Seite 881). Insbesondere ist Ba-Oxalat merklich in Wasser löslich.

Gemäß US-Patent 4 804 649 wird durch Copräzipitation aus einer wäßrigen Lösung, die Salze von Y, Ba und Cu enthält, mit alkalischer Oxalatlösung ein basisches Oxalat erhalten. Aber auch hier können die zu Beginn der Fällung und bei Ende der Fällung entstehenden Oxalate unterschiedliche Kationen-Verhältnisse aufweisen, so daß beim Tempern des Produktes u.a. geringe Mengen an BaCuO₂ und Y₂BaCuO₅ auftreten können. Ferner ist bei diesem Verfahren das restlose Auswaschen von überschüssiger Natronlauge nicht ganz einfach.

Es bestand daher die Aufgabe, einen Kuper enthaltenden oxidkeramischen Supraleiter, insbesondere auf Basis von YBa₂Cu₃O₇₋ₓ herzustellen, bei dem die bekannten Atomverhältnisse der Metalle im Ausgangsmaterial genau eingehalten werden.

Es wurde nun ein Verfahren zur Herstellung eines kupferhaltigen, oxidkeramischen Supraleiters, der noch mindestens 2 Metalle ausgewählt aus der Gruppe Y, Ba, Ca, Sr, Tl, Pb, La oder der Seltenen Erden enthält, gefunden, bei dem man eine Lösung bereitet, die die Metallanteile des Supraleiters in den berechneten Mengen in Form löslicher Salze enthält, man durch Vereinigung mit mindestens der äquivalenten Menge Oxalsäurelösung die Metalle als Oxalat ausfällt, man das Gemisch der Oxalate abtrennt, trocknet, bis zur thermischen Zersetzung erhitzt und anschließend in Gegenwart von Sauerstoff zum Supraleiter reagieren läßt und abkühlt.

Dieses Verfahren ist dadurch gekennzeichnet, daß man 3 % bis 10 % der umzusetzenden Metallsalzlösung mit der Oxalsäure-Lösung vereinigt, man den entstehenden Niederschlag abfiltriert und verwirft, man das (jetzt an Oxalaten gesättigte) Filtrat mit dem Rest der Metallsalzlösung vereinigt, den entstehenden Niederschlag abfiltriert, trocknet und zum Supraleiter weiterverarbeitet.

Im allgemeinen wird freie Oxalsäure in Form wäßriger Lösungen eingesetzt. Man kann jedoch auch mit einer alkalischen Oxalat-Lösung wie in US-PS 4 804 649 beschrieben arbeiten. Man kann auch die Oxalsäure und/oder die Metallsalze in Lösemitteln reagieren lassen, die mit Wasser mischbar sind. Dies bringt aber keine zusätzlichen Vorteile.

Vorzugsweise wird die Oxalsäure (das Oxalat) in einem Überschuß von mindestens 10 %, insbesondere mindestens 50 % eingesetzt. Ein besonders feines Oxalat erhält man, wenn man bei der Herstellung des zweiten Niederschlags die Metallsalzlösung vernebelt , z.B. mit der in der DE-OS 36 32 396 angegebenen Methode, und den Nebel in Kontakt bringt mit einer gerührten Oxalsäure-Lösung.

Das angegebene Verfahren eignet sich insbesondere zur Herstellung oxidkeramischen Supraleitern, die kein Wismut enthalten, vorzugsweise zur Herstellung von YBa₂Cu₃O_{Z}, aber auch für LaBa₂Cu₃O_{Z}, LnBa₂Cu₃O_{Z} (wobei Ln für ein Element der Seltenen Erden steht), Y₁₋ₓCaₓBa₂Cu₃O₇, YSr₂Cu₃O₇, La₁₊ₓBa₂₋ₓCu₃O₇, La₂₋ₓSrₓCuO₄, Ln₂₋ₓCeₓCuO₄, Tl₂Ba₂CaCuO₈, Tl₂Ba₂Ca₂CU₃O₁₀, Tl₂Ba₂₋ₓSrₓCaCu₂O₈, TlBa₂Cu₃O₉, Pb₂Sr₂Ca₁₋ₓYₓCu₃O₈.

Als Salze eignen sich, je nach Löslichkeit, z.B. die Chloride, Sulfate, Zitrate oder Nitrate. Die Fällung erfolgt vorzugsweise bei tiefen Temperaturen, z.B. bei 0 - 10°C.

Der entstandene hellblaue Niederschlag wird zunächst mit Wasser oder einem mit Wasser mischbaren organischen Lösemittel, beispielsweise Ethanol, gewaschen und dann, z.B. bei 110°C 3 Stunden getrocknet. Die thermische Zersetzung erfolgt bei Temperaturen von 200 bis 400°C im Sauerstoff-Strom. Die anschließende Reaktion zum Supraleiter, bei gepreßten Formkörpern unter Sintern, erfolgt bei 900 bis 950°C, vorzugsweise bei 920 bis 930°C, im Sauerstoffstrom. Das Sintern eines Preßkörpers aus YBa₂Cu₃O₉ setzt nach dilatometrischen Untersuchungen bei 800°C ein, d.h. um 100 K tiefer als bei herkömmlichen Proben. Anschließend kann durch Tempern bei 400 - 500°C der eigentliche Supraleiter erhalten werden.

Die nach dem angegebenen Verfahren synthetisierten Supraleiter-Pulver wurden mit röntgenographischen Pulvermethoden und analytischer Gehaltsbestimmung mit Hilfe der Mikrosonde als phasenrein identifiziert. Sie sind sehr feinkörnig. Ihre Primärteilchengröße liegt unter 1 µm.

Der zuerst entstandene Oxalat-Niederschlag hat eine Zusammensetzung, die nicht exakt mit der der Metallsalz-Lösung übereinstimmt. Er wird nicht zu Supraleitern weiterverarbeitet. Man kann jedoch durch thermische Zersetzung dieses Oxalats ein Mischoxid gewinnen, dieses in Salpetersäure lösen, die Lösung neutralisieren, nach Analyse mit den fehlenden Kationen "aufstärken" und für einen neuen Ansatz verwenden.

Die Erfindung wird durch das Beispiel näher erläutert:

### Beispiel:

4,521 g Y(NO₃)₃·5 H₂O (12,4 mmol), 6,476 g Ba(NO₃)₂ (24,8 mmol) und 8,976 g Cu(NO₃)₂·3 H₂O (37,2 mmol) werden in 220 ml Wasser bei Zimmertemperatur gelöst. 20,3 g Oxalsäure (161 mmol/100 % Überschuß) werden bei 5°C in 365 ml Wasser gelöst und vorgelegt. 10 % der Metallsalzlösung werden mit Ultraschall in die Oxalsäurelösung eingebracht, der Niederschlag wird abfiltriert und die restliche Metallsalzlösung in einem Zeitraum von ca. 1 Stunde mit Hilfe von Ultraschall versprüht. Hierzu wurde die in der DE-OS 36 32 396 beschriebene Apparatur verwendet.

In einer Entfernung von ca. 5 cm unterhalb des Ultraschallzerstäubers befand sich in einem Becherglas eine kräftig gerührte Lösung von Oxalsäure in Wasser bei 5°C. Nach Beendigung der Zerstäubung wurde der entstandene Niederschlag abzentrifugiert und im Trockenschrank 4 Stunden bei 110°C getrocknet. Nach einer chemischen Analyse betrug das Atomverhältnis 0,96 Y: 1,95 Ba: 3 Cu.

Zur Calcinierung (Umwandlung des Oxalats in den Supraleiter) wurde das getrocknete Pulver in 10 Stunden auf 400°C aufgeheizt, im Sauerstoffstrom 5 Stunden bei 400°C gehalten, dann in 4 Stunden auf die Temperatur Tₘₐₓ aufgeheizt und während mindestens 10 Stunden bei dieser Temperatur gehalten. Anschließend wurde in 6 Stunden auf Raumtemperatur abgekühlt. Die Temperatur Tₘₐₓ liegt im allgemeinen bei 800 bis 930°C. Bei niedrigen Temperaturen (800°C) erhält man feine Pulver und man muß mehrere Tage sintern, damit das gesamte Bariumcarbonat thermisch zersetzt ist. Bei höheren Temperaturen (930°C) sintert das Pulver schon zusammen. Dafür reicht eine Dauer von 10 Stunden aus.

Das Pulver wird anschließend noch 10 Stunden bei 400°C unter Sauerstoffatmosphäre nachgetempert, um den Sauerstoffgehalt auf den für die Supraleitung erforderliche Höhe zu bringen.

## Patentansprüche

1. Verfahren zur Herstellung eines Kupfer enthaltenden oxidkeramischen Supraleiters, der neben Kupfer noch mindestens zwei Metalle ausgewählt aus der Gruppe Y, Ba, Ca, Sr, La, Tl, Pb oder der Seltenen Erden enthält, wobei man eine wäßrige Lösung bereitet, die die Metallanteile des Supraleiters in den berechneten Atomverhältnissen in Form löslicher Salze enthält, man durch Vereinigung mit mindestens der äquivalenten Menge einer Oxalsäure-Lösung die Metalle als Oxalat ausfällt, man das Gemisch der Oxalate abtrennt, trocknet, bis zur thermischen Zersetzung erhitzt und anschließend in Gegenwart von Sauerstoff zum Supraleiter reagieren läßt, dadurch gekennzeichnet, daß man 3 bis 10 % der umzusetzenden Metallsalzlösung mit der Oxalsäure-Lösung vereinigt, man den entstehenden Niederschlag abfiltriert und verwirft, man das Filtrat mit dem Rest der Metallsalzlösung vereinigt, den entstehenden Niederschlag abfiltriert, trocknet und weiterverarbeitet.

2. Verfahren nach Anspruch 1, dadurch gekennzeichnet, daß eine wäßrige Oxalsäurelösung eingesetzt wird.

3. Verfahren nach Anspruch 1, dadurch gekennzeichnet, daß man eine Metallsalzlösung einsetzt, die Ionen von Y³⁺, Ba²⁺ und Cu²⁺ im Atomverhältnis 1:2:3 enthält.

4. Verfahren nach Anspruch 1, dadurch gekennzeichnet, daß man die Lösung der Metallsalze mittels Ultraschall vernebelt und den Nebel in Kontakt mit der Oxalsäurelösung bringt.

## Claims

1. A process for the preparation of a copper-containing, ceramic oxide superconductor which contains, in addition to copper, at least two metals selected from the group comprising Y, Ba, Ca, Sr, La, Tl, Pb and the rare earths, in which an aqueous solution is prepared which contains, in the form of soluble salts, the metal components of the super-conductor in the atomic ratios calculated, the metals are precipitated as oxalates by combining the solution with at least the equivalent amount of an oxalic acid solution, and the mixture of the oxalates is separated off, dried, heated until thermal decomposition and subsequently allowed to react in the presence of oxygen to form the superconductor, which comprises combining from 3 to 10 % of the metal salt solution to be reacted with the oxalic acid solution, filtering off and discarding the precipitate produced, combining the filtrate with the remainder of the metal salt solution, filtering off and drying the precipitate produced, and processing the material further.

2. The process as claimed in claim 1, wherein an aqueous oxalic acid solution is employed.

3. The process as claimed in claim 1, wherein a metal salt solution is employed which contains the ions of Y³⁺, Ba²⁺ and Cu²⁺ in the atomic ratio 1:2:3.

4. The process as claimed in claim 1, wherein the solution of the metal salts is atomized by means of ultrasound, and the mist is brought into contact with the oxalic acid solution.

## Revendications

1. Procédé de préparation d'un supraconducteur de céramique oxydée contenant du cuivre qui contient, en plus du cuivre, au moins deux autres métaux choisis dans le groupe constitué par Y, Ba, Ca, Sr, La, Tl, Pb ou les terres rares, selon lequel on prépare une solution aqueuse qui contient les constituants métalliques du supraconducteur sous forme de sels solubles dans les rapports atomiques calculés, on précipite les métaux sous forme d'oxalates par combinaison avec une quantité au moins équivalente d'une solution d'acide oxalique, on sépare le mélange des oxalates, on le sèche, on le chauffe jusqu'à la décomposition thermique et on le fait réagir ensuite en présence d'oxygène pour former le supraconducteur, caractérisé en ce que l'on combine 3 à 10 % de la solution de sels métalliques à transformer avec la solution d'acide oxalique, on filtre et on jette le précipité formé, on combine le filtrat avec le reste de la solution de sels métalliques, on filtre le précipité formé, on le sèche et on le soumet au traitement ultérieur.

2. Procédé selon la revendication 1, caractérisé en ce que l'on utilise une solution aqueuse d'acide oxalique.

3. Procédé selon la revendication 1, caractérisé en ce que l'on utilise une solution de sels métalliques qui contient des ions Y³⁺, Ba²⁺ et Cu²⁺ dans un rapport atomique de 1:2:3.

4. Procédé selon la revendication 1, caractérisé en ce que l'on atomise la solution de sels métalliques à l'aide d'ultrasons et en ce que l'on met en contact le brouillard avec la solution d'acide oxalique.
